(19) Europäisches Patentamt / European Patent Office / Office européen des brevets

(11) **EP 3 985 078 A1**

(12) **EUROPEAN PATENT APPLICATION**
published in accordance with Art. 153(4) EPC

(43) Date of publication:
**20.04.2022 Bulletin 2022/16**

(21) Application number: **20825877.2**

(22) Date of filing: **15.06.2020**

(51) International Patent Classification (IPC):
**C09K 3/14** (2006.01)  **B24B 37/00** (2012.01)
**H01L 21/304** (2006.01)

(52) Cooperative Patent Classification (CPC):
**B24B 37/00; C09K 3/14; H01L 21/304**

(86) International application number:
**PCT/JP2020/023398**

(87) International publication number:
**WO 2020/255921 (24.12.2020 Gazette 2020/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.06.2019 JP 2019112283**

(71) Applicant: **Fujimi Incorporated**
**Kiyosu-shi, Aichi 452-8502 (JP)**

(72) Inventors:
• **ITO, Yasuaki**
  **Kiyosu-shi, Aichi 452-8502 (JP)**
• **TAKAMI, Shinichiro**
  **Kiyosu-shi, Aichi 452-8502 (JP)**
• **MORI, Yoshio**
  **Kiyosu-shi, Aichi 452-8502 (JP)**

(74) Representative: **Grünecker Patent- und Rechtsanwälte**
**PartG mbB**
**Leopoldstraße 4**
**80802 München (DE)**

(54) **POLISHING COMPOSITION**

(57) Provided is a polishing composition that can reduce the friction force against an object to be polished while maintaining a favorable polishing removal rate. The polishing composition provided by the present invention contains water, an abrasive, and a composite metal oxide as an oxidant. The polishing composition further contains an anionic polymer. In some preferred embodiments, the polishing composition contains a permanganate as the composite metal oxide. The polishing composition is suitable for polishing a material having a Vickers hardness of 1500 Hv or higher.

## Description

## Technical Field

The present invention relates to polishing compositions, and specifically, to a polishing composition used for polishing an object to be polished. The present application claims priority based on Japanese Patent Application No. 2019-112283 filed on 17 June 2019, the entire contents of which application are incorporated herein by reference.

## Background Art

Conventionally, polishing has been performed using polishing compositions on surfaces of material such as metals, metalloids, nonmetals, and their oxides. An object to be polished that has a surface made of a compound semiconductor material, such as silicon carbide, boron carbide, tungsten carbide, silicon nitride, titanium nitride, or gallium nitride, for example, can be processed by polishing (lapping), which is performed by supplying a diamond abrasive between the object to be polished and a polishing platen in contact with the surface of the object. However, in lapping using a diamond abrasive, defects and strains are likely to occur due to the generation, remaining and the like of scratches and dents. For this reason, studies have been conducted on polishing that is performed using a polishing pad by supplying a polishing slurry to between the polishing pad and an object to be polished, after lapping using a diamond abrasive or instead of this lapping. Examples of literature in which this kind of related art is disclosed include Patent Literatures 1 to 4.

Citation List

Patent Literature

Patent Literature 1: Japanese Patent Application Publication No. 2000-049124
Patent Literature 2: Japanese Patent Application Publication No. 2012-135863
Patent Literature 3: WO 2018/116521
Patent Literature 4: WO 2016/158328

## Summary of Invention

Technical Problem

In general, from the viewpoint of manufacturing efficiency and cost, it is desirable that the polishing removal rate should be large enough for practical use when polishing an object to be polished by supplying a polishing slurry. For example, in the polishing of the object to be polished that is made of a material having high hardness such as silicon carbide, further improvement in the polishing removal rate is desired from the standpoint of improving the yield of polished objects.

In order to achieve the improvement in the polishing removal rate for this kind of object to be polished through the setting of polishing conditions, there are proposed methods, one of which involves increasing the processing pressure by increasing the load applied to an object to be polished during polishing, and the other of which involves increasing the rotation speed of a platen in a polishing machine. However, there is a concern that the above-described methods may cause problems, such as damage to the object to be polished, due to an increase in frictional force. If a polishing slurry that can effectively reduce the friction generated during polishing can be provided, such problems are less likely to occur even when the polishing conditions are made more severe, for example, under a high processing pressure or at a high-speed rotation of a platen, which is beneficial for further improvement in the polishing removal rate.

The present invention has been made in view of the above circumstances, and an object of the present invention is to provide a polishing composition that can reduce the friction against an object to be polished while maintaining a favorable polishing removal rate. Solution to Problem

According to the present invention, a polishing composition which contains water, an abrasive, and a composite metal oxide as an oxidant is provided. The polishing composition further contains an anionic polymer.

When the abrasive (for example, an alumina abrasive, a silica abrasive, or the like) and the composite metal oxide are used in combination, the polishing composition with excellent polishing removal ability can be obtained. Thus, with the configuration containing the water, the abrasive, and the composite metal oxide, the polishing removal rate is easily improved. The anionic polymer can reduce the friction while maintaining a favorable polishing removal rate by acting on a polishing target surface of an object to be polished and/or surfaces of the abrasive particles. Thus, according to the polishing composition containing the anionic polymer in addition to the water, the abrasive, and the composite metal oxide, the friction against the object to be polished can be reduced while exhibiting a favorable polishing removal rate.

According to a preferred aspect of the art disclosed here, a polishing composition that contains water, an alumina abrasive, and a composite metal oxide as an oxidant is provided. The polishing composition further contains an anionic polymer.

When the alumina abrasive and the composite metal oxide are used in combination, the polishing composition with excellent polishing removal ability can be obtained. Thus, with the configuration containing the water, the alumina abrasive, and the composite metal oxide, the polishing removal rate is easily improved. The anionic polymer can reduce the friction while maintaining a favorable polishing removal rate by acting on a polishing target surface of an object to be polished and/or surfaces of the abrasive particles. Thus, according to the polishing composition containing the anionic polymer in addition to the water, the alumina abrasive, and the composite metal oxide, the friction against the object to be polished can be reduced while exhibiting a favorable polishing removal rate.

According to a preferred aspect of the art disclosed here, the anionic polymer is a homopolymer or copolymer that contains, in one molecule, at least one of a sulfonic acid-derived structural unit, a (meth)acrylic acid-derived structural unit, or an acrylamide-derived structural unit. Using such an anionic polymer makes it easier to realize the polishing composition that can reduce the friction against an object to be polished (typically, a material to be polished) while exhibiting a favorable polishing removal rate.

In a preferred aspect of the art disclosed here, the anionic polymer is a homopolymer or copolymer that contains, in one molecule, at least one structural unit derived from styrenesulfonic acid, isoprene sulfonic acid, vinylsulfonic acid, allylsulfonic acid, isoamylene sulfonic acid, 2-(meth)acrylamido-2-methylpropanesulfonic acid, or methallylsulfonic acid. Using such an anionic polymer makes it easier to realize the polishing composition that can reduce the friction against an object to be polished while exhibiting a favorable polishing removal rate.

In a preferred aspect of the art disclosed here, the anionic polymer is a homopolymer or copolymer that contains, in one molecule, at least one structural unit derived from acrylic acid or methacrylic acid. Using such an anionic polymer makes it easier to realize the polishing composition that can reduce the friction against an object to be polished while exhibiting a favorable polishing removal rate.

In a preferred aspect of the art disclosed here, the anionic polymer is a copolymer that contains a sulfonic acid-derived structural unit, a (meth)acrylic acid-derived structural unit, and an acrylamide-derived structural unit. Using such an anionic polymer makes it easier to realize the polishing composition that can reduce the friction against an object to be polished while exhibiting a favorable polishing removal rate.

In the polishing composition according to a preferred aspect disclosed here, the composite metal oxide contains a permanganate as the composite metal oxide. With such a configuration, the polishing removal rate is easily improved.

In a polishing composition according to a preferred aspect disclosed here, a pH of the polishing composition is 2.5 or higher and 9.0 or lower. In the polishing composition with its pH being in the above range, the friction reduction effect tends to be favorably exhibited by the anionic polymer.

In a preferred aspect of the art disclosed here, the polishing composition is used for polishing a material having a Vickers hardness of 1500 Hv or higher. The application effect of the present invention can be exhibited suitably in the polishing composition where the material to be polished is a material having high hardness. In a preferred aspect, the material having a Vickers hardness of 1500 Hv or higher is a non-oxide (i.e., a compound which is not an oxide). The polishing removal acceleration effect by the oxidant contained in the polishing composition disclosed here is easily exhibited suitably in polishing the material to be polished, which is made of the non-oxide.

Herein, a method for polishing an object to be polished is further provided. The polishing method includes a step of polishing an object to be polished using any of the polishing compositions disclosed here. According to the polishing method, even when polishing the object to be polished which is made of the material having high hardness, a high polishing removal rate can be achieved while suppressing the occurrence of troubles such as damage to the object to be polished.

**Description of Embodiments**

Preferred embodiments of the present invention will be described below. Incidentally, matters that are other than those particularly mentioned herein but are necessary for implementation of the present invention can be recognized by those skilled in the art as design matters based on the prior art in the relevant field. The present invention can be implemented based on contents disclosed herein and common general technical knowledge in the field.

<Polishing composition>

(Abrasive)

The material and properties of the abrasive are not particularly limited. For example, the abrasive can be composed of any of inorganic particles, organic particles, and organic-inorganic composite particles. Examples thereof include abrasives substantially composed of any one of oxide particles such as silica particles, alumina particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate. The abrasives may be used alone or in combination of two or more kinds. Among these, oxide particles such as silica particles, alumina particles, cerium oxide particles, chromium oxide particles, zirconium oxide particles, manganese dioxide particles, and iron oxide particles are preferable because they enable a favorable surface to be formed. Among these, silica particles, alumina particles, zirconium oxide particles, chromium oxide particles, and iron oxide particles are more preferable, and silica particles and alumina particles are particularly preferable. In the embodiment using silica particles or alumina particles as the abrasive, the effect of reducing the friction against the object to be polished can be suitably exhibited by applying the art disclosed here.

The abrasive serves to mechanically polish an object to be polished. In a preferred embodiment of the art disclosed here, the polishing composition contains alumina particles (alumina abrasive) as the abrasive. When alumina particles are used, they can be appropriately selected from among various known alumina particles. Examples of such known alumina particles include $\alpha$-alumina and an intermediate alumina. Here, the intermediate alumina is a general term for alumina particles other than $\alpha$-alumina, and specific examples thereof include $\gamma$-alumina, $\delta$-alumina, $\theta$-alumina, $\eta$-alumina, $\kappa$-alumina, and $\chi$-alumina. Alternatively or additionally, one kind of alumina called fumed alumina based on classification according to a production method (typically, alumina fine particles produced when sintering an alumina salt at high temperature) may be used. Furthermore, another kind of alumina called colloidal alumina or alumina sol (for example, alumina hydrate such as boehmite) is also included among examples of the known alumina particles. From the viewpoint of the processability, it is preferred to include $\alpha$-alumina. The alumina abrasives in the art disclosed here may include one kind of such alumina particles alone or two or more kinds of the alumina particles in combination.

When alumina particles are used as the abrasive, a high proportion of alumina particles with respect to the entire abrasive to be used is generally advantageous. For example, the proportion of the alumina particles with respect to the entire abrasive is preferably 70 % by weight or more, more preferably 90 % by weight or more, and even more preferably 95 % by weight or more, and may be substantially 100 % by weight.

The particle size of the alumina abrasive is not particularly limited and may be selected so that the desired polishing effect can be exhibited. From the viewpoint of polishing removal rate and the like, the BET diameter of the alumina abrasive is preferably 0.05 $\mu$m or more, more preferably 0.1 $\mu$m or more, even more preferably 0.2 $\mu$m or more, and particularly preferably 0.3 $\mu$m or more. The upper limit of the BET diameter of the alumina abrasive is not particularly limited, but is appropriately set to about 10 $\mu$m or less. In order to improve surface quality, the BET diameter of the alumina abrasive is preferably 5 $\mu$m or less, more preferably 3 $\mu$m or less, and even more preferably 1 $\mu$m or less, for example, 0.8 $\mu$m or less. The range of the BET diameter of the alumina abrasive may be between 0.2 $\mu$m and 1.0 $\mu$m, inclusive, or between 0.3 $\mu$m and 0.8 $\mu$m, inclusive. In the art disclosed here, the BET diameter of an abrasive can be calculated from the specific surface area (BET value) measured by a BET method, using the formula of BET diameter (nm) = 6000/(true density (g/cm$^3$) $\times$ BET value (m$^2$/g)), unless otherwise noted. The BET diameter of an abrasive can typically be the average primary particle size of the abrasive. The BET diameter is measured by a method described in examples below.

When alumina particles are used as the abrasive, generally, the content of the alumina abrasive in the polishing composition (the total content of alumina particles in the case of including several kinds of alumina particles) is generally appropriately 1 % by weight or more from the viewpoint of polishing removal rate. In order to improve the polishing removal rate, the content of the alumina abrasive in the polishing composition is preferably 3 % by weight or more, and more preferably 4 % by weight or more, and may be 5 % by weight or more. From the viewpoint of dispersibility, polishing stability and the like, the content of the alumina abrasive in the polishing composition is generally appropriately 50 % by weight or less, preferably 20 % by weight or less, and more preferably 15 % by weight or less, and may be 10 % by weight or less, or 8 % by weight or less.

When alumina particles are used as the abrasive, the polishing composition disclosed here may further contain another kind of abrasive made of material other than the above-described alumina (hereinafter also referred to as a non-alumina abrasive) as long as the effects of the present invention are not impaired. Examples of such a non-alumina abrasive include abrasives substantially composed of any one of oxide particles such as silica particles, cerium oxide particles, chromium oxide particles, titanium dioxide particles, zirconium oxide particles, magnesium oxide particles, manganese oxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate.

The content of the non-alumina abrasive is, for example, appropriately 30 % by weight or less, preferably 20 % by weight or less, and more preferably 10 % by weight or less with respect to the total weight of the abrasive contained in the polishing composition.

In another preferred embodiment of the art disclosed here, the polishing composition contains silica particles (silica abrasive) as the abrasive. When the silica abrasive is used, it can be appropriately selected from among various known silica particles. Examples of such known silica particles include colloidal silica, dry silica, and the like. Among these, colloidal silica is preferably used. According to the silica abrasive containing colloidal silica, the favorable surface smoothness can be suitably achieved.

The shape (outer shape) of the silica abrasive may be globular or non-globular. For example, specific examples of the non-globular shape of the silica abrasive include a peanut shape (i.e., a peanut shell shape), a cocoon shape, a conpeito shape, a rugby-ball shape, etc. In the art disclosed here, the silica abrasive may be in the form of primary particles or secondary particles into which a plurality of primary particles are aggregated. Alternatively or additionally, a silica abrasive in the form of primary particles and a silica abrasive in the form of secondary particles may be mixed. In a preferred embodiment, at least part of the silica abrasive is contained in the polishing composition in the form of secondary particles.

The silica abrasive having a BET diameter of more than 5 nm can be preferably adopted. From the viewpoint of polishing removal rate and the like, the BET diameter of the silica abrasive is preferably 15 nm or more, more preferably 20 nm or more, even more preferably 25 nm or more, and particularly preferably 30 nm or more. The upper limit of the BET diameter of the silica abrasive is not particularly limited, but is generally appropriately set to about 120 nm or less, and it is preferably 100 nm or less, and more preferably 85 nm or less. For example, in order to achieve both polishing removal rate and surface quality at higher levels, a silica abrasive having a BET diameter of 12 nm to 80 nm, inclusive, is preferred, or a silica abrasive having a BET diameter of 15 nm to 75 nm, inclusive, is also preferred. The BET diameter is measured by a method described in examples below.

The average secondary particle size of the silica abrasive (hereinafter sometimes referred to simply as "D2") is not particularly limited, but from the viewpoint of polishing removal rate and the like, it is preferably 20 nm or more, more preferably 50 nm or more, and even more preferably 70 nm or more. In order to obtain a surface of higher quality, the average secondary particle size D2 of the silica abrasive is appropriately 500 nm or less, preferably 300 nm or less, more preferably 200 nm or less, even more preferably 130 nm or less, and particularly preferably 110 nm or less (for example, 100 nm or less).

In the art disclosed here, the average secondary particle size of the abrasive can be measured as a volume average particle size (volume-based arithmetic average size; Mv) by a dynamic light scattering method using a model "UPA-UT151" commercially available from Nikkiso Co., Ltd., for example.

When silica particles are used as the abrasive, the content of the silica abrasive in the polishing composition (the total content of silica particles in the case of including several kinds of silica particles) is generally appropriately 5 % by weight or more from the viewpoint of polishing removal rate. In order to improve the polishing removal rate, the content of the silica abrasive in the polishing composition is preferably 10 % by weight or more, more preferably 15 % by weight or more, and even more preferably 20 % by weight or more, and may be 25 % by weight or more. From the viewpoint of dispersibility, polishing stability, and the like, the content of the silica abrasive in the polishing composition is generally appropriately 60 % by weight or less, preferably 50 % by weight or less, more preferably 40 % by weight or less, and even more preferably 35 % by weight or less, and may be 32 % by weight or less, or 30 % by weight or less.

The polishing composition disclosed here may not substantially contain diamond particles as the abrasive. Diamond particles can be a factor limiting the improvement in the smoothness because of their high hardness. In addition, since diamond particles are generally expensive, they cannot be said to be a beneficial material in terms of cost performance, and the dependence on expensive materials such as diamond particles may be low from the viewpoint of practical use. Here, the expression that the abrasive does not substantially contain diamond particles means that the proportion of diamond particles in the entire abrasive is 1 % by weight or less, more preferably 0.5 % by weight or less, and typically 0.1 % by weight or less, and includes the case where the proportion of diamond particles is 0 % by weight. In such an embodiment, the application effect of the present invention can be suitably exhibited.

<Anionic polymer>

The polishing composition disclosed here contains an anionic polymer. The anionic polymer can act as a friction reducing agent that reduces the friction caused by direct contact between the abrasive and an object to be polished, while maintaining a favorable polishing removal rate by acting on a polishing target surface of the object to be polished and/or surfaces of the abrasive particles.

Here, the anionic polymer refers to a polymer composed of repeating structural units having an anionic group. The anionic group refers to a functional group that exhibits an anionic property in at least some pH range. The anionic polymer may be a homopolymer in which the repeating structural units constituting the anionic polymer are all the same, or a heteropolymer (copolymer) in which different kinds of repeating structural units are contained. The anionic polymer disclosed here is preferably a water-soluble polymer.

Examples of the anionic polymer include carboxylic acid-based polymers such as polyacrylic acid, sulfonic acid-based polymers such as polystyrene sulfonic acid, and the like. According to such an anionic polymer, a suitable friction reduction effect can be exhibited while maintaining a favorable polishing removal rate. These anionic polymers can be used alone or in combination of two or more kinds.

The anionic polymer according to a preferred embodiment is a homopolymer or copolymer that contains, in one molecule, at least one of a sulfonic acid-derived structural unit, a (meth)acrylic acid-derived structural unit, or an acrylamide-derived structural unit. According to such an anionic polymer, a suitable friction reduction effect can be exhibited while maintaining a favorable polishing removal rate. The term "(meth)acrylic acid" as used herein means the concept that encompasses one or both of acrylic acid and methacrylic acid. These anionic polymers can be used alone or in combination of two or more types.

In a preferred embodiment, a sulfonic acid-based polymer is used as the anionic polymer. Here, the sulfonic acid-based polymer refers to a polymer that contains a structural unit X derived from a monomer which has at least one sulfonic acid group in one molecule, as a monomer unit that constitutes the sulfonic acid-based polymer. Examples of the monomer having a sulfonic acid group include styrenesulfonic acid, isoprene sulfonic acid, vinylsulfonic acid, allylsulfonic acid, isoamylene sulfonic acid, 2-(meth)acrylamido-2-methylpropanesulfonic acid, methallylsulfonic acid, and the like. The sulfonic acid-based polymer preferably includes any one or two or more kinds of the structural units X derived from the above-described sulfonic acid group-containing monomer. The sulfonic acid-based polymer may also contain a component unit derived from a monomer other than the sulfonic acid group-containing monomer.

A suitable example of the sulfonic acid-based polymer disclosed here is a sulfonic acid-based polymer A that is substantially composed only of the structural units X derived from the sulfonic acid group-containing monomer. In other words, in the sulfonic acid-based polymer A, the proportion (molar ratio) of the number of moles of the above-described structural unit X with respect to the number of moles of all structural units contained in a molecular structure of the polymer is preferably 99 mol% or more (for example, 99.9 mol% or more, typically 99.9 mol% to 100 mol%). Examples of such a sulfonic acid-based polymer A include a homopolymer composed only of one kind of sulfonic acid group-containing monomer disclosed here, and a heteropolymer (copolymer) composed of two or more kinds of sulfonic acid group-containing monomers. Examples of the homopolymer include polystyrene sulfonic acid, polyisoprene sulfonic acid, polyvinyl sulfonic acid, polyaryl sulfonic acid, polyisoamylene sulfonic acid, and the like.

The weight average molecular weight (Mw) of the sulfonic acid-based polymer may be, for example, 500 or more, 1000 or more, or 2000 or more. In order to improve the friction reduction effect, in some embodiments, Mw of the sulfonic acid-based polymer is preferably 3000 or more, and more preferably 5000 or more, and may be 7000 or more, 9000 or more, 11000 or more, 20000 or more, or 30000 or more. The upper limit of Mw of the sulfonic acid-based polymer is not particularly limited and may be, for example, $150 \times 10^4$ or less, $100 \times 10^4$ or less, $50 \times 10^4$ or less, $30 \times 10^4$ or less, $20 \times 10^4$ or less, $10 \times 10^4$ or less, or $7 \times 10^4$ or less. As the Mw of the sulfonic acid copolymer, the weight average molecular weight (aqueous, based on standard polyethylene glycol) which is determined by gel permeation chromatography (GPC) can be adopted.

Another favorable example of the sulfonic acid-based polymer disclosed here is a (meth)acrylic acid/sulfonic acid copolymer that contains a structural unit derived from (meth)acrylic acid and the structural unit X derived from the sulfonic acid group-containing monomer. Such a (meth)acrylic acid/sulfonic acid copolymer may contain any one kind or two or more kinds of the structural units X derived from the above-described sulfonic acid group-containing monomers. The (meth)acrylic acid/sulfonic acid copolymer may contain a component derived from a monomer, other than the sulfonic acid group-containing monomer and the (meth)acrylic acid monomer. Examples of the above-described (meth)acrylic acid/sulfonic acid copolymer include a (meth)acrylic acid/isoprene sulfonic acid copolymer, a (meth)acrylic acid/2-acrylamido-2-methylpropanesulfonic acid copolymer, a (meth)acrylic acid/isoprene sulfonic acid/2-acrylamido-2-methylpropanesulfonic acid copolymer, and the like. For example, the above-described (meth)acrylic acid/sulfonic acid copolymer may contain a component derived from an acrylamide monomer, other than the sulfonic acid group-containing monomer and the (meth)acrylic acid monomer. An example of the above-described (meth)acrylic acid/sulfonic acid copolymer is a (meth)acrylic acid/2-acrylamido-2-methylpropanesulfonic acid copolymer.

The molecular weight of the above-described (meth)acrylic acid/sulfonic acid copolymer may be, for example, 500 or more, 1000 or more, or 2000 or more. In order to improve the friction reduction effect, in some embodiments, Mw of the (meth)acrylic acid/sulfonic acid copolymer is preferably 3000 or more, and more preferably 5000 or more, and may be 7000 or more, or 9000 or more. The upper limit of Mw of the (meth)acrylic acid/sulfonic acid copolymer is not particularly limited and may be, for example, $150 \times 10^4$ or less, $100 \times 10^4$ or less, $50 \times 10^4$ or less, $30 \times 10^4$ or less, $20 \times 10^4$ or less, $10 \times 10^4$ or less, $7 \times 10^4$ or less, $5 \times 10^4$ or less, $3 \times 10^4$ or less, or $1.5 \times 10^4$ or less. As the Mw of the (meth)acrylic acid/sulfonic acid copolymer, the weight average molecular weight (aqueous, based on standard polyethylene glycol) which is determined by the GPC can be adopted.

The above-described (meth)acrylic acid/sulfonic acid copolymer may be a random copolymer, a block copolymer, or a graft copolymer. The proportion (molar ratio) of the number of moles of the structural unit X derived from the sulfonic acid group-containing monomer with respect to the number of moles of all repeating units constituting the (meth)acrylic acid/sulfonic acid copolymer is not particularly limited. The above ratio may be, for example, 5 mol% or more, or 10 mol% or more. In order to improve the friction reduction effect, in an embodiment, the above ratio may be 20 mol% or more (for example, 25 mol% or more). Further, in an embodiment, the above ratio may also be, for example, 95 mol% or less, 90 mol% or less, 80 mol% or less, or further 70 mol% or less (for example, 40 mol% or less).

In a preferred embodiment, a (meth)acrylic acid-based polymer containing structural units derived from (meth)acrylic acid is used as the anionic polymer. Typical examples of the above-described (meth)acrylic acid-based polymer include polyacrylic acid and polymethacrylic acid. Among these, polyacrylic acid is preferred.

The Mw of the (meth)acrylic acid-based polymer may be, for example, 500 or more, 700 or more, 1000 or more, or 1500 or more. The upper limit of Mw of the (meth)acrylic acid-based polymer is not particularly limited and may be, for example, $15 \times 10^4$ or less, $10 \times 10^4$ or less, $5 \times 10^4$ or less, $1 \times 10^4$ or less, 7000 or less, 5000 or less, or 4000 or less. As the Mw of the (meth)acrylic acid-based polymer, the weight average molecular weight (aqueous, based on standard polyethylene glycol) which is determined by the GPC can be adopted.

The anionic polymer may be used in the form of neutralized salt. Examples of the neutralized salt include salts of alkali metal such as Na and K, ammonium salts, alkylammonium salts, and the like.

The Mw of the anionic polymer may be, for example, 500 or more, 700 or more, 1000 or more, or 1500 or more. The upper limit of Mw of the anionic polymer is not particularly limited and may be, for example, $150 \times 10^4$ or less, $100 \times 10^4$ or less, $50 \times 10^4$ or less, $30 \times 10^4$ or less, $20 \times 10^4$ or less, $10 \times 10^4$ or less, or $7 \times 10^4$ or less. As the Mw of the anionic polymer, the weight average molecular weight (aqueous, based on standard polyethylene glycol) which is determined by the GPC can be adopted.

The content of the anionic polymer in the polishing composition (the total content of anionic polymers in an embodiment where the polishing composition contains a plurality of kinds of anionic polymers) is not particularly limited. The content of the anionic polymer is, for example, appropriately 0.001 g/L or more (or more than 0.001 g/L). In order to effectively exhibit the friction reduction effect, the above content is preferably 0.005 g/L or more (or more than 0.005 g/L), more preferably 0.01 g/L or more, and even more preferably 0.05 g/L or more. Further, in order to maintain a favorable polishing removal rate, the above content is appropriately 5.0 g/L or less, preferably 2.0 g/L or less, and more preferably 1.0 g/L or less, and may be, for example, 0.8 g/L or less, 0.6 g/L or less, or 0.3 g/L or less.

For example, when a (meth)acrylic acid-based polymer is used as the anionic polymer, the content of the (meth)acrylic acid-based polymer in the polishing composition is not particularly limited. The content of the (meth)acrylic acid-based polymer is, for example, appropriately 0.001 g/L or more (or more than 0.001 g/L). In order to effectively exhibit the friction reduction effect, the above content is preferably 0.005 g/L or more (or more than 0.005 g/L), more preferably 0.01 g/L or more, and even more preferably 0.05 g/L or more. Further, in order to maintain the favorable polishing rate, the above content is appropriately 5.0 g/L or less, preferably 2.0 g/L or less, and more preferably 1.0 g/L or less, and may be, for example, 0.8 g/L or less, 0.6 g/L or less, 0.5 g/L or less, or 0.25 g/L or less.

<Non-anionic polymer>

The polishing composition disclosed here may or may not further contain a polymer other than the anionic polymer (a non-anionic polymer). As the non-anionic polymer, any of nonionic polymers, cationic polymers, and amphoteric polymers can be used. The non-anionic polymer is preferably a water-soluble polymer.

An example of the non-anionic polymer usable in the polishing composition disclosed here is a polymer containing nitrogen atoms. Non-limiting examples of the polymer containing nitrogen atoms include: a polymer containing a monomer unit of an N-vinyl type; a polymer containing a monomer unit of an N-(meth)acryloyl type; and the like. Examples of the polymer that contains monomer units of the N-vinyl type include polymers containing repeating units derived from a monomer having a nitrogen-containing heterocycle (for example, a lactam ring). Specific examples of such a polymer include a homopolymer composed of N-vinyl lactam type monomers, and a copolymer thereof (for example, a copolymer containing N-vinyl lactam type monomers at a copolymerization ratio of more than 50 % by weight).

Specific examples of the N-vinyl lactam type monomer (i.e., a compound having a lactam structure and N-vinyl group in one molecule) include N-vinylpyrrolidone (VP), N-vinyl piperidone, N-vinyl morpholinone, N-vinyl caprolactam (VC), N-vinyl-1,3-oxazine-2-one, N-vinyl-3,5-morpholinedione, and the like. Specific examples of the polymer containing N-vinyl lactam type monomer units include polyvinylpyrrolidone, polyvinylcaprolactam, a random copolymer of VP and VC, a random copolymer of one or both of VP and VC and another vinyl monomer (for example, an acrylic monomer, a vinyl ester monomer, or the like), a block copolymer or a graft copolymer including a polymer chain containing one or both of VP and VC. Specific examples of the polymer containing one of VP and VC include polyvinylpyrrolidone vinyl acetate copolymer and the like.

Examples of the polymer containing the N-(meth)acryloyl type monomer units include a homopolymer composed of N-(meth)acryloyl type monomers, and a copolymer thereof (for example, a copolymer containing the N-(meth)acryloyl type monomers at a copolymerization ratio of more than 50 % by weight). Examples of the N-(meth)acryloyl type monomer include cyclic amides having N-(meth)acryloyl groups.

Examples of the cyclic amide having an N-(meth)acryloyl group include N-acryloyl morpholine, N-acryloyl thiomorpholine, N-acryloyl piperidine, N-acryloyl pyrrolidine, N-methacryloyl morpholine, N-methacryloyl piperidine, N-methacryloyl pyrrolidine, and the like. An example of a polymer that contains a cyclic amide having an N-(meth)acryloyl group as a monomer unit is an acryloyl morpholine-based polymer (PACMO). Typical examples of the acryloyl morpholine-based polymer include a homopolymer composed of N-acryloyl morpholine (ACMO), and a copolymer of ACMO (for example, a copolymer containing ACMO at a copolymerization ratio of more than 50 % by weight). The proportion (molar ratio) of the number of moles of the ACMO unit with respect to the number of moles of all repeating units in the acryloyl morpholine-based polymer is generally 50 mol% or more, and appropriately 80 mol% or more (for example, 90 mol% or more, or 95 mol% or more). All repeating units of the non-anionic polymer may be essentially composed of ACMO units.

Specific examples of the non-anionic polymer include polyvinyl acetate and the like. In addition, specific examples of the non-anionic polymer include polyaluminum chloride, ferric polysulfate, and the like.

The non-anionic polymers can be used alone or in combination of two or more kinds.

The content of the non-anionic polymer (the total content of non-anionic polymers in an embodiment where the polishing composition contains a plurality of kinds of non-anionic polymers) is not particularly limited. In order to maintain a favorable polishing removal rate, the ratio ($W_y/W_x$) of the non-anionic polymer content $W_y$ [% by weight] to the anionic polymer content $W_x$ [% by weight] is preferably less than 1, more preferably 0.5 or less, even more preferably 0.2 or less, and particularly preferably 0.1 or less.

In order to maintain a more favorable polishing removal rate, the polishing composition can be preferably implemented in an embodiment where it does not substantially contain a non-anionic polymer. The state in which the polishing composition does not substantially contain a non-anionic polymer as used herein refers to a state in which it does not contain a non-anionic polymer at least intentionally. Typically, this means that the content of the non-anionic polymer in the polishing composition is 0.001 % by weight or less, and preferably 0.0001 % by weight or less, and encompasses that the content of the non-anionic polymer is 0 % by weight.

(Oxidant)

The polishing composition disclosed here contains an oxidant. The oxidant can exhibit the effect of improving the polishing removal rate in polishing of an object to be polished (for example, silicon carbide). The polishing composition disclosed here contains a composite metal oxide as the oxidant. Examples of the above composite metal oxides include nitrate metal salts, ferric acids, permanganic acids, chromic acids, vanadic acids, ruthenic acids, molybdic acids, rhenium acids, and tungstic acids. Among them, ferric acids, permanganic acids, and chromic acids are more preferable, and permanganic acids (for example, permanganates) are even more preferable.

Specific examples of the composite metal oxide include nitrate metal salts such as iron nitrate and silver nitrate; ferric acids such as potassium ferrate; permanganic acids such as sodium permanganate and potassium permanganate; chromic acids such as potassium chromate and potassium dichromate; vanadic acids such as sodium vanadate and potassium vanadate; ruthenic acids such as salts of perruthenic acid; molybdic acids such as ammonium molybdate and disodium molybdate; rhenium acids such as salts of perrhenic acid; and tungstic acids such as disodium tungstate. The composite metal oxides can be used alone or in combination of two or more kinds.

In some of the preferred embodiments, a composite metal oxide that includes a monovalent or divalent metal element (other than transition metal elements) and a transition metal element in the fourth period in the periodic table is used as the composite metal oxide. Suitable examples of the monovalent or divalent metal element include Na, K, Mg, and Ca. Among them, Na and K are more preferable. Suitable examples of the transition metal element in the fourth period in the periodic table include Fe, Mn, Cr, V, and Ti. Among them, Fe, Mn, and Cr are more preferable, and Mn is even more preferable. The composite metal oxide can effectively reduce the hardness of the surface of a material having high hardness such as silicon carbide and also cause embrittlement in this surface. Thus, the polishing removal rate improving effect can be more suitably exhibited.

When the above composite metal oxide is a salt (for example, a permanganate), the composite metal oxide may exist in an ionic state in the polishing composition.

The polishing composition disclosed here may further contain an oxidant other than the composite metal oxide. Oxidants other than composite metal oxides include, for example, peroxides such as hydrogen peroxide. The art disclosed here can be preferably performed in an embodiment where the composite metal oxide (for example, vanadic acids) and an oxidant (for example, hydrogen peroxide) other than the composite metal oxide are used in combination as the oxidant.

In an embodiment where hydrogen peroxide and any of vanadic acids (for example, sodium metavanadate) are used in combination as the oxidant, the ratio (C2/C1) of the content C2 of hydrogen peroxide to the content C1 of the vanadic acids is not particularly limited and is appropriately 0.5 or more and 5 or less, preferably 1 or more and 4 or less, and more preferably 1.5 or more and 3 or less, based on the weight. By using the above compounds in combination at a specific content ratio, both the polishing removal rate and the surface quality can be achieved at higher levels.

The polishing composition disclosed here may not contain an oxidant other than the composite metal oxide. The art disclosed here can be preferably performed in a mode where an oxidant (for example, hydrogen peroxide) other than the composite metal oxide is not substantially contained as the oxidant.

The content of the oxidant (for example, a permanganate) in the polishing composition is generally appropriately 0.005 mol/L or more. From the viewpoint of polishing removal rate, the content of the oxidant (for example, a permanganate) is preferably 0.008 mol/L or more, and more preferably 0.01 mol/L or more, and may be 0.03 mol/L or more, 0.05 mol/L or more, 0.06 mol/L or more, or 0.07 mol/L or more. Further, from the viewpoint of the surface quality after the polishing, the content of the oxidant (for example, a permanganate) in the polishing composition is generally appropriately 0.5 mol/L or less, preferably 0.3 mol/L or less, and more preferably 0.2 mol/L or less, and may be 0.1 mol/L or less, or 0.09 mol/L or less.

In another preferred embodiment, the content of the oxidant (for example, vanadic acids) in the polishing composition is generally appropriately 0.005 mol/L or more. From the viewpoint of polishing removal rate, the content of the oxidant (for example, vanadic acids) is preferably 0.01 mol/L or more, and more preferably 0.05 mol/L or more, and may be 0.08 mol/L or more, 0.1 mol/L or more, 0.15 mol/L or more, or 0.18 mol/L or more. Further, from the viewpoint of the surface quality after the polishing, the content of the oxidant (for example, vanadic acid) in the polishing composition is generally appropriately 1.0 mol/L or less, preferably 0.8 mol/L or less, and more preferably 0.5 mol/L or less, and may be 0.3 mol/L or less, or 0.2 mol/L or less.

In another preferred embodiment, the content of the oxidant (for example, hydrogen peroxide) in the polishing composition is generally appropriately 0.05 mol/L or more. From the viewpoint of polishing removal rate, the content of the oxidant (for example, hydrogen peroxide) other than the composite metal oxide is preferably 0.1 mol/L or more, and more preferably 0.2 mol/L or more, and may be 0.25 mol/L or more, 0.3 mol/L or more, 0.35 mol/L or more, or 0.4 mol/L or more. Further, from the viewpoint of the surface quality after the polishing, the content of the oxidant (for example, hydrogen peroxide) other than the composite metal oxide in the polishing composition is generally appropriately 5.0 mol/L or less, preferably 2 mol/L or less, and more preferably 1 mol/L or less, and may be 0.7 mol/L or less, or 0.5 mol/L or less.

(Water)

The polishing composition disclosed here contains water. As the water, ion-exchange water (deionized water), pure water, ultrapure water, distilled water, or the like can be preferably used. The polishing composition disclosed here may further contain an organic solvent (lower alcohol, lower ketone, or the like) that can be uniformly mixed with water as necessary. Generally, it is appropriate that 90 vol% or more of the solvent contained in the polishing composition is water, it is preferable that 95 vol% or more thereof is water, and it is more preferable that 99 to 100 vol% thereof is water.

(Acid)

The polishing composition can contain an acid as necessary for the purpose of pH adjustment, polishing removal acceleration, and the like. As the acid, both inorganic and organic acids can be used. Examples of inorganic acids include sulfuric acid, nitric acid, hydrochloric acid, carbonic acid, and the like. Examples of organic acids include aliphatic carboxylic acids such as formic acid, acetic acid and propionic acid, aromatic carboxylic acids such as benzoic acid and phthalic acid, citric acid, oxalic acid, tartaric acid, malic acid, maleic acid, fumaric acid, succinic acid, organic sulfonic acid, organic phosphonic acid, and the like. These can be used alone or in combination of two or more kinds. When using an acid, the amount of the acid used is not particularly limited, and can be set according to the purpose of use (for example, pH adjustment). Alternatively, in some embodiments of the polishing composition disclosed here, the polishing composition may not substantially contain any acid.

(Basic compound)

The polishing composition can contain a basic compound as necessary for the purpose of pH adjustment, polishing removal acceleration, and the like. The basic compound as used herein refers to a compound that has the function of increasing a pH of the polishing composition by being added to the composition. Examples of the basic compound include alkali metal hydroxides such as potassium hydroxide and sodium hydroxide; carbonates or hydrogencarbonates such as ammonium bicarbonate, ammonium carbonate, potassium bicarbonate, potassium carbonate, sodium bicarbonate, and sodium carbonate; ammonia; quaternary ammonium hydroxides such as quaternary ammonium hydroxides including tetramethylammonium hydroxide, tetraethylammonium hydroxide, and tetrabutylammonium hydroxide; others, such as amines, phosphates and hydrogen phosphates; and organic acid salts. The basic compounds can be used alone or in combination of two or more kinds. When using a basic compound, the amount of the basic compound used is not particularly limited, and can be set according to the purpose of use (for example, pH adjustment). Alternatively, in some embodiments of the polishing composition disclosed here, the polishing composition may not substantially contain any basic compound.

(Other components)

As long as the effects of the present invention are not impaired, the polishing composition disclosed here may further contain, as necessary, known additives that can be used for a polishing composition (for example, a polishing composition used for polishing a material having high hardness, such as silicon carbide), such as a chelating agent, a thickener, a dispersant, a surface protective agent, a wetting agent, a surfactant, a corrosion inhibitor, an antiseptic agent, and an antifungal agent. Since the content of the additive may be appropriately set according to the purpose of addition thereof and does not characterize the present invention, a detailed description thereof will be omitted.

(Oxidation-reduction potential)

The oxidation-reduction potential (hereinafter also referred to as ORP: Oxidation-Reduction Potential) of the polishing composition disclosed here is not particularly limited. From the viewpoint of polishing removal rate or the like, the ORP of the polishing composition is appropriately 400 mV or more, preferably 600 mV or more, and more preferably 650 mV or more (for example, 750 mV or more, or 800 mV or more). The upper limit of the ORP of the polishing composition is not particularly limited, but in order to easily obtain a surface of higher quality or the like, it is preferably 1500 mV or less, more preferably 1300 mV or less, and even more preferably 1200 mV or less (for example, 1000 mV or less, or 950 mV or less).
The ORP of the polishing composition can be adjusted by appropriately selecting the kinds of the abrasive and the oxidant and the ratio of the content of the abrasive to that of the oxidant. As a method for adjusting the ORP of the polishing composition, for example, a method in which a pH of the polishing composition is changed can also be adopted. The methods for controlling the ORP can be used alone or in combination. The ORP of the polishing composition is measured by a method described in examples below.

(Zeta potential)

According to the art disclosed here, the friction reduction effect is exhibited by addition of the anionic polymer. Such a friction reduction effect can be exhibited more significantly when the anionic polymer is further added to a composition Co containing an abrasive that shows a predetermined zeta potential $\zeta_0$. The absolute value of the zeta potential $\zeta_0$ of the abrasive in the composition Co before the addition of the anionic polymer (typically, the composition that has the same components as the polishing composition except that the anionic polymer is not contained) is preferably 110 mV or less, more preferably 90 mV or less, even more preferably 70 mV or less, and particularly preferably 50 mV or less, and may be, for example, 40 mV or less, 30 mV or less, or 25 mV or less. With a configuration in which the absolute value of the zeta potential $\zeta_0$ of the abrasive in the composition Co is lower than or equal to the predetermined value described above, the friction reduction effect can be favorably exhibited by using the anionic polymer disclosed here. The zeta potential $\zeta_0$ of the abrasive in the composition $C_0$ is measured by a method described in examples below.
The reason why the friction reduction effect is improved when the anionic polymer is added to the composition Co containing the abrasive showing a zeta potential $\zeta_0$ within the predetermined range is not to be interpreted in any particular way, but can be considered, for example, as follows. That is, in a composition Co where the absolute value of the zeta potential $\zeta_0$ of the abrasive is relatively large, particles of the abrasive are considered to be favorably dispersed by being electrically repelled each other. On the other hand, in a composition Co where the absolute value of the zeta potential $\zeta_0$ of the abrasive is relatively small, the dispersibility of the abrasive tends to be degraded. Here, it is considered that the anionic polymer functions to suppress the direct contact between the abrasive and the object to be polished by acting on abrasive surfaces or the like. Such a friction reduction effect by the addition of the anionic polymer can be exhibited more effectively in the composition $C_0$ where the dispersibility of the abrasive tends to be degraded. Therefore, the friction reduction effect tends to be improved particularly when the anionic polymer is added to the composition Co in which the absolute value of the zeta potential $\zeta_0$ of the abrasive is less than or equal to a predetermined value.
The zeta potential $\zeta_A$ of the abrasive in the polishing composition disclosed here is not particularly limited. The zeta potential $\zeta_A$ of the abrasive in the polishing composition is generally appropriately 5 mV or more, preferably 10 mV or more, and more preferably 13 mV or more, for example, 20 mV or more. The larger the absolute value of the zeta potential $\zeta_A$, the more strongly the particles of the abrasive are electrically repelled each other, which tends to improve the dispersion stability of the abrasive in the polishing composition. The upper limit of the absolute value of the zeta potential $\zeta_A$ is not particularly limited, but generally appropriately 175 mV or less, preferably 100 mV or less, more preferably 80 mV or less, and even more preferably 70 mV or less (for example, 60 mV or less, or 50 mV or less). The zeta potential $\zeta_A$ of the abrasive in the polishing composition is measured by a method described in examples below.

(pH)

The pH of the polishing composition is generally appropriately about 2 to 12. When the pH of the polishing composition is within the above range, a practical polishing removal rate is easily achieved in polishing an object to be polished. In some embodiments, the pH of the polishing composition may be 2.5 or higher, 3.0 or higher, 4.0 or higher, 5.0 or higher, or 5.5 or higher. Although the upper limit of the pH is not particularly limited, in some embodiments, the pH of the polishing composition may be 12.0 or lower, 10.0 or lower, 9.0 or lower (for example, lower than 9.0), 8.0 or lower (for example, lower than 8.0), 7.0 or lower, or 6.8 or lower.

The pH of the polishing composition may affect the zeta potential $\zeta_A$ of particles in the polishing composition. In order to adjust the zeta potential $\zeta_A$ to a level that can exhibit the friction reduction effect more effectively in the art disclosed here, the pH of the polishing composition is preferably 3.0 or higher, more preferably 4.0 or higher, and even more preferably 5.0 or higher (for example, 5.5 or higher). Further, in order to improve the friction reduction effect through stabilization of the ionization state of the anionic polymer in the polishing composition, the pH of the polishing composition is preferably 8.0 or lower, more preferably 7.0 or lower, and even more preferably 6.8 or lower.

In a preferred embodiment of the polishing composition disclosed here, the pH of the polishing composition is 4.0 or higher and lower than 8.0. Within such a pH range, the friction reduction effect tends to be favorably exhibited by the anionic polymer. From this perspective, the pH of the polishing composition is more preferably 5.0 or higher and 7.0 or lower, and even more preferably 5.5 or higher and 6.8 or lower.

(Electrical conductivity)

The electrical conductivity of the polishing composition disclosed here is not particularly limited. The electrical conductivity of the polishing composition is generally appropriately 5 mS/cm or higher, preferably 7 mS/cm or higher, and even more preferably 8 mS/cm or higher (for example, 8.5 mS/cm or higher, or 8.6 mS/cm or higher). The upper limit of the electrical conductivity of the polishing composition is not particularly limited, but is generally appropriately 40 mS/cm or lower, preferably 30 mS/cm or lower, more preferably 15 mS/cm or lower, even more preferably 13 mS/cm or lower, and particularly preferably 11 mS/cm or lower (for example, 10.5 mS/cm or lower, or 8.8 mS/cm or lower). In the polishing composition that shows the electrical conductivity in the above-described predetermined range, the friction reduction effect is favorably exhibited by using the anionic polymer disclosed here.

As used herein, the electrical conductivity of the polishing composition refers to an electrical conductivity measured under the condition that the content of the abrasive in the polishing composition is 6 % by weight. The electrical conductivity of the polishing composition is measured by the method described in the examples below.

A method for adjusting the electrical conductivity of the polishing composition is not particularly limited. The above electrical conductivity can be adjusted, for example, by a method in which an appropriate amount of electrolyte (salt, acid, alkali, or the like) is blended into the polishing composition, a method in which the polishing composition is diluted or concentrated, or a method in which ion-exchange treatment is applied to some or all of the components of the polishing composition. The methods for adjusting the electrical conductivity may be used alone or in combination of two or more kinds.

A method for preparing the polishing composition disclosed here is not particularly limited. For example, the respective components contained in the polishing composition may be mixed using a well-known mixing device such as a blade type stirrer, an ultrasonic disperser, a homomixer or the like. An embodiment in which these components are mixed is not particularly limited, and, for example, all components may be mixed at once or may be mixed according to an appropriately set order.

(Properties)

The polishing composition according to a preferred embodiment disclosed here satisfies the following properties regarding the coefficient of friction and the polishing removal rate which are measured in polishing tests performed under predetermined conditions. In other words, in a polishing test using a polishing pad with a polishing slurry supplied between the polishing pad and the object to be polished, the coefficient of friction $F_A$ and the polishing removal rate $R_A$ which are measured using the above polishing composition as the polishing slurry have the following relationships with the coefficient of friction Fo and the polishing removal rate $R_0$ which are measured using a comparison composition: $F_A/F_0 \leq 0.9$; and $R_A/R_0 > 0.8$. Here, the comparative composition has the same composition as the above polishing composition except that it does not contain the above anionic polymer as the polishing slurry.

According to the polishing composition that satisfies these properties, the friction against the object to be polished is reduced while maintaining a favorable polishing removal rate. Thus, the polishing using the polishing composition that satisfies such properties easily improves the flexibility in polishing conditions. Therefore, in the polishing using the polishing composition, the polishing removal rate for the object to be polished can be improved more.

Here, the polishing test is performed by a method described in examples below. In other words, in the polishing test, an object described in the examples below is used as the object to be polished. In addition, polishing in the polishing test is performed under the conditions described in the examples below. The coefficients of friction $F_A$ and Fo and the polishing removal rates $R_A$ and Ro are measured by respective methods described in the examples below. Typically, the pH of the above polishing composition is equal to or approximated to the pH of the above comparative composition. A difference between the pH of the polishing composition and the pH of the comparison composition is preferably 2.0 or less, more preferably 1.5 or less, even more preferably 1.0 or less (for example, 0.8 or less), and may be 0.5 or less, 0.3 or less, or 0.2 or less.

In order to reduce the friction, the ratio $F_A/F_0$ of the coefficient of friction of the polishing composition to that of the comparison composition in the above polishing test is preferably 0.95 or less, more preferably 0.9 or less, and even more preferably 0.85 or less (for example, 0.81 or less). The lower limit of the above $F_A/F_0$ is not particularly limited, but in order to maintain a favorable polishing removal rate, it may be 0.5 or more, 0.6 or more, or 0.7 or more.

In order to improve the polishing removal rate, the ratio $R_A/R_0$ of the polishing removal rate of the polishing composition to that of the comparison composition in the above polishing test is more preferably 0.9 or more, even more preferably 0.95 or more, and particularly preferably 0.98 or more (for example, 1 or more). The upper limit of the $R_A/R_0$ (polishing removal rate ratio) is not particularly limited, but in order to reduce the friction, the $R_A/R_0$ is 1.5 or less and may be 1.3 or less.

<Object to be polished>

An object to be polished for the polishing composition disclosed here is not particularly limited. For example, the polishing composition disclosed here can be applied for polishing a substrate that has a surface made of a compound semiconductor material, i.e., a compound semiconductor substrate. Examples of a constituent material for the compound semiconductor substrate is not particularly limited, but include: semiconductors of Groups II-VI compounds such as cadmium telluride, zinc selenide, cadmium sulfide, cadmium mercury telluride, and zinc cadmium telluride; semiconductors of Groups III-V compounds such as gallium nitride, gallium arsenide, gallium phosphide, indium phosphide, aluminum gallium arsenide, indium gallium arsenide, indium gallium arsenide nitride, and aluminum gallium indium phosphide; semiconductors of Groups IV-IV compounds such as silicon carbide and germanium silicide; and the like. The object to be polished may be made of a plurality of materials selected from these materials described above. In a preferred embodiment, the polishing composition disclosed here can be applied for polishing a substrate that has a surface made of a compound semiconductor material which is not an oxide (i.e., non-oxide). The polishing removal acceleration effect is easily exhibited in a suitable manner by the oxidant contained in the polishing composition disclosed here, when polishing the substrate that has the surface made of the compound semiconductor material which is a non-oxide.

The polishing composition disclosed here can be preferably used for polishing the surface of the object to be polished that has a Vickers hardness of 500 Hv or higher, for example. The above Vickers hardness is preferably 700 Hv or higher, for example, 1000 Hv or higher, or 1500 Hv or higher. The Vickers hardness of a material to be polished may be 1800 Hv or higher, 2000 Hv or higher, or 2200 Hv or higher. Material having a high Vickers hardness tends to be brittle and vulnerable to impacts, and thus it may be damaged easily depending on the polishing conditions. For this reason, it is more meaningful to apply the polishing composition of the present invention to such a material to be polished. The upper limit of the Vickers hardness of the surface of the object to be polished is not particularly limited and may be, for example, about 7000 Hv or lower, 5000 Hv or lower, or 3000 Hv or lower. The Vickers hardness as used herein can be measured based on JIS R 1610:2003. The international standard corresponding to the above JIS standard is ISO 14705:2000.

Examples of a material having a Vickers hardness of 1500 Hv or higher include silicon carbide, silicon nitride, titanium nitride, gallium nitride and the like. The object to be polished in the art disclosed here can have a single crystal surface of the material that is mechanically and chemically stable. Among them, the surface of the object to be polished is preferably made of any of silicon carbide and gallium nitride, and more preferably made of silicon carbide. Silicon carbide is expected to be a compound semiconductor substrate material having less power loss and excellent heat resistance and the like, and has a particularly large practical advantage of improving surface properties. The art disclosed here can be particularly preferably applied to the polishing of a single crystal surface of silicon carbide.

<Polishing method>

The polishing composition disclosed here can be used for polishing an object to be polished, for example, in an embodiment including the following operations.

That is, a polishing slurry containing any of the polishing compositions disclosed here is prepared. Preparation of the polishing slurry may include preparation of a polishing slurry by performing operations such as concentration adjustment (for example, dilution) and pH adjustment on the polishing composition. Alternatively, the polishing composition may be directly used as a polishing slurry. In addition, in the case of a multi-agent type polishing composition, preparation of the polishing slurry may include mixing such agents, diluting one or a plurality of agents before the mixing, diluting the resulting mixture after the mixing, and the like.

Next, the polishing slurry is supplied to the object to be polished, and the object is then polished by general methods, which are adopted by those skilled in the art. For example, in one method among them, an object to be polished is set in a general polishing machine, and the polishing slurry is supplied to a polishing target surface of the object through a polishing pad of the polishing machine. Typically, while supplying the polishing slurry continuously, the polishing pad is pressed against the polishing target surface of the object to be polished, and both of the object and the pad are moved (for example, rotated) relative to each other. Polishing of the object to be polished is completed through such a polishing step.

According to the description herein, a polishing method in which an object to be polished (typically, a material to be polished) is polished and a method in which a polished object is produced using the polishing method are provided. The polishing method is characterized by including a step of polishing an object to be polished using the polishing composition disclosed here. A polishing method according to a preferred embodiment includes a step of performing preliminary polishing (stock polishing step) and a step of performing final polishing (final polishing step). In a typical embodiment, the stock polishing step is a polishing step set immediately before the final polishing step. The stock polishing step may be a single-step of polishing or a polishing step in two or more sub-steps. The final polishing step as used herein refers to a step of performing final polishing on an object to be polished on which the preliminary polishing has been performed, specifically, a polishing step set at the end (that is, on the most downstream side), among polishing steps performed using a polishing slurry containing an abrasive. In such a polishing method including the stock polishing step and the final polishing step, the polishing composition disclosed here may be used in the stock polishing step, may be used in the final polishing step, or may be used in both the stock polishing step and the final polishing step.

In a preferred embodiment, the polishing step using the polishing composition may be a stock polishing step. When the stock polishing step is a polishing step including two or more sub-steps, any of the polishing compositions disclosed here can also be used to perform two or more sub-steps of the polishing step. The polishing composition disclosed here can be preferably applied to stock polishing as a preceding sub-step (on the upstream side). For example, the polishing composition can also be preferably used in the first stock polishing step, typically, the primary polishing step, after a lapping step described below.

In another preferred embodiment, the polishing step using the polishing composition is a final polishing step. The polishing composition disclosed here is suitable as a polishing composition (final polishing composition) used in the final polishing step of the surface of the object to be polished, because it can reduce the number of dents and defects on the polished surface.

The stock polishing and the final polishing can be applied to both polishing using a single-side polishing machine and polishing using a double-side polishing machine. In the single-side polishing machine, an object to be polished is adhered to a ceramic plate with wax, or the object to be polished is held using a holder called a carrier. Then, while a polishing composition is supplied, a polishing pad is pressed against one side of the object to be polished, and both of the polishing pad and the object are moved relative to each other, thereby polishing one side of the object. The above movement is, for example, rotation. In the double-side polishing machine, an object to be polished is held using a holder called a carrier. Then, while a polishing composition is supplied from above, a polishing pad is pressed against opposing sides of the object to be polished, and both of the polishing pad and the object are rotated in a relative direction, so that both sides of the object to be polished are polished at the same time.

The polishing pad used in each polishing step disclosed here is not particularly limited. For example, any polishing pad of a non-woven fabric type, a suede type, a hard foamed polyurethane type, a type containing an abrasive, and a type containing no abrasive may be used. In some embodiments, a polishing pad of a suede type that does not contain an abrasive can be preferably adopted.

A polished object that is polished by the method disclosed here is typically cleaned after polishing. This cleaning can be performed using an appropriate cleaning solution. The cleaning solution to be used is not particularly limited, and known or conventional cleaning solutions can be appropriately selected and used.

The polishing method disclosed here may include any other step in addition to the stock polishing step and the final polishing step described above. Examples of such a step include a lapping step performed before the stock polishing step. The lapping step is a step of polishing an object to be polished by pressing the surface of a polishing platen, for example, a cast iron platen, against the object to be polished. Therefore, in the lapping step, no polishing pad is used. The lapping step is typically performed by supplying an abrasive between the polishing platen and the object to be polished. The abrasive is typically a diamond abrasive. In addition, the polishing method disclosed here may include an additional step before the stock polishing step or between the stock polishing step and the final polishing step. The additional step is, for example, a cleaning step or a polishing step.

<Method for producing polished object>

The art disclosed here may include provision of a method for producing a polished object which includes a polishing step using any of the polishing methods described above and a polished object produced by the method. The production method of the polished object is, for example, a method for producing a silicon carbide substrate. That is, the art disclosed here provides a method for producing a polished object which includes polishing an object made of a material to be polished by applying any of the polishing methods disclosed here, and also provides a polished object produced by this method. According to the above production method, a polished object, for example, a silicon carbide substrate, which has improved surface quality, can be efficiently produced.

Examples

Several examples relating to the present invention will be described below, but the present invention is not intended to be limited to those indicated in the examples.

Here, in the following description, "%" is on a weight basis unless otherwise specified.

Anionic polymers used in the following examples were as follows.

Polymer A1: sodium polystyrene sulfonate (manufactured by Tosoh Organic Chemical Co.,Ltd., product name "Poly-Nass (registered trademark) PS-1", Mw 10000)
Polymer A2: sodium polystyrene sulfonate (manufactured by Tosoh Organic Chemical Co.,Ltd., product name "Poly-Nass (registered trademark) PS-5", Mw 50000)
Polymer B: sodium polyacrylate (manufactured by Toagosei Co., Ltd., product name "A-210", Mw 3000)
Polymer C: acrylic acid/2-acrylamido-2-methylpropanesulfonic acid copolymer sodium salt (Mw10000)

It is noted that the Mw of the above polymers is the manufacturer's nominal value.

<Test Example 1>

<Preparation of polishing composition>

(Example 1)

An alumina abrasive, potassium permanganate ($KMnO_4$) as an oxidant, an anionic polymer, and deionized water were mixed to prepare a polishing composition of this example. The content of the alumina abrasive was 6%, the content of the potassium permanganate was 0.079 mol/L, and the content of the anionic polymer was 0.08 g/L. The pH of the polishing composition was adjusted to be a value shown in Table 1 by using nitric acid and/or potassium hydroxide (KOH). As the alumina abrasive, an $\alpha$-alumina abrasive having a BET diameter of 0.5 $\mu$m was used. The BET diameter of the abrasive was measured using a surface area measuring device (product name "Flow Sorb II 2300"), manufactured by Micromeritics Instrument Corp. As the anionic polymer, sodium polystyrene sulfonate (polymer A2) having a Mw of 50000 was used.

(Examples 2 and 3)

Polishing compositions of these examples were prepared in the same procedure as in Example 1 except that the kind of the anionic polymer and the content thereof were set as shown in Table 1.

(Comparative Example 1)

A polishing composition of this example was prepared in the same procedure as in Example 1 except that no anionic polymer was used.

(Example 4)

A polishing composition of this example was prepared in the same procedure as in Example 1 except that sodium polystyrene sulfonate (polymer A1) having a Mw of 10000 was used as the anionic polymer, and the pH of the polishing composition was adjusted to be a value shown in Table 1 by using nitric acid and/or KOH.

(Examples 5 to 7)

Polishing compositions of these examples were prepared in the same procedure as in Example 4 except that the kind of the anionic polymer and the content thereof were set as shown in Table 1.

(Comparative Example 2)

A polishing composition of this example was prepared in the same procedure as in Example 4 except that no anionic polymer was used.

(Example 8)

A polishing composition of this example was prepared in the same procedure as in Example 1 except that the pH of the polishing composition was adjusted to be a value shown in Table 1 by using nitric acid and/or KOH.

(Comparative Example 3)

A polishing composition of this example was prepared in the same procedure as in Example 8 except that no anionic polymer was used.

(Examples 9 to 15)

Polishing compositions of these examples were prepared in the same procedure as in Example 1 except that the kind of the anionic polymer and the content thereof were set as shown in Table 2.

(Measurement of zeta potential)

For the polishing compositions of respective examples, a zeta potential [mV] was measured using a high concentration zeta potential meter (ZetaProbe) manufactured by Colloidal Dynamics, LLC on a condition of a liquid temperature of 20 to 25°C. The resulting absolute values of the zeta potentials are shown in the "Zeta potential absolute value" columns of Tables 1 and 2.

(Measurement of Oxidation-reduction potential)

For the polishing compositions of respective examples, an oxidation-reduction potential ORP [mV] with respect to a standard hydrogen electrode was measured using an oxidation-reduction potentiometer, manufactured by HORIBA, Ltd. (main unit model: F-52, electrode model: 9300) on a condition of a liquid temperature of 20 to 25°C. The measurement results are shown in the "ORP" columns of Tables 1 and 2.

(Measurement of electrical conductivity)

For the polishing compositions of respective examples, an electrical conductivity [mS/cm] was measured using a conductivity meter manufactured by HORIBA, Ltd. (model "DS-71", electrode used "3552-10D") on a condition of a liquid temperature of 20 to 25°C. The measurement results are shown in the "Electrical conductivity" columns of Tables 1 and 2.

<Preliminary polishing of object to be polished>

An alumina abrasive (6 % by weight) having a BET diameter of 0.5 $\mu$m and permanganic acid (0.105 mol/L) as an oxidant were mixed, and a pH adjustment agent was added to the mixture such that a pH of the mixture is 8 or more and 10 or less, thereby preparing a preliminary polishing composition. Then, using the prepared preliminary polishing composition, preliminary polishing was performed on a SiC wafer until the following surface qualities were obtained. The conditions for the preliminary polishing were the same as the polishing conditions in the <Polishing of object to be polished> chapter below.

The preliminary polishing was performed such that the surface roughness Ra, measured with an atomic force microscope (model nanoscope V), manufactured by Bruker corporation, was less than or equal to 0.07 nm with regard to the surface quality after the preliminary polishing.

<Polishing of object to be polished>

Polishing was performed on the polished surface of the object to be polished after the preliminary polishing described above, directly using the polishing compositions of respective examples as the polishing slurry under the following conditions.

[Polishing conditions]

Polishing machine: model "RDP-500" manufactured by Fujikoshi Machinery Corp.

Polishing pad: "SUBA800XY" manufactured by Nitta Haas Incorporated
Polishing pressure: 29.4 kPa
Flow rate of polishing slurry: 20 mL/minute
Platen rotational speed: 100 rpm
Head rotational speed: 100 rpm
Polishing time: 1 hour
Object to be polished: SiC wafer (conductivity type: n-type, crystalline type 4H-SiC, off angle with respect to the C axis of the main surface (0001): 4°), 2 inches, 1 sheet/batch Temperature of polishing slurry: 23°C

<Evaluation of polishing removal rate>

Polishing was performed directly using the polishing compositions of respective examples as the polishing slurry under the above polishing conditions. The polishing removal rate was calculated according to the following calculation formulas (1) and (2).

$$(1)\ \text{Polishing removal [cm]} = \text{a difference in weight of a SiC wafer before and after polishing}$$

$$\text{[g]/density of SiC [g/cm}^3\text{]} (= 3.21\ \text{g/cm}^3\text{)/polishing target area [cm}^2\text{]} (= 19.62\ \text{cm}^2)$$

$$(2)\ \text{Polishing removal rate [nm/h]} = \text{polishing removal [cm]} \times 10^7\text{/polishing time} (= 1\ \text{hour})$$

The resulting values were converted into relative values on the assumption that a corresponding value of the comparative example showing a pH in the same range as the used polishing composition was 100%, and the converted values are shown in the "Relative polishing removal rate" columns of Tables 1 and 2.

<Evaluation of coefficient of friction>

The coefficient of friction was measured when polishing was performed directly using the polishing composition of each example as the polishing slurry under the above polishing conditions. When measuring the coefficient of friction, a template with a backing pad made of suede material was used as a wafer holding part, and the wafer was adhered to the template so that a protruding height of the wafer was more than or equal to 200 μm. In polishing, the wafer was kept being stuck to the suede material with water. As the coefficient of friction, a value directly output from the polishing machine was adopted.

The resulting value here was converted into a relative value on the assumption that a corresponding value of the comparative example showing a pH in the same range as the used polishing composition was 100%, and the converted values are shown in the "Relative coefficient of friction" columns of Tables 1 and 2.

[Table 1]

Table 1

| | Anionic polymer | | Polishing composition | | | | Evaluation | |
|---|---|---|---|---|---|---|---|---|
| | Type | Content [g/L] | pH | Absolute value of zeta potential [mV] | ORP [mV] | Electrical conductivity [mS/cm] | Relative polishing removal rate [%] | Relative coefficient of friction [%] |
| Example 1 | A2 | 0.08 | 5.88 | 15 | 846 | 8.72 | 104 | 90 |
| Example 2 | B | 0.16 | 6.82 | 42 | 802 | 8.92 | 103 | 86 |
| Example 3 | C | 0,1.6 | 4.59 | 27 | 935 | 8.76 | 100 | 81 |
| Comparative Example 1 | - | 0 | 5.66 | 14 | 859 | 8.85 | 100 | 100 |
| | | | | | | | | |
| Example 4 | A1 | 0.08 | 8.75 | 41 | 672 | 8.97 | 101 | 97 |
| Example 5 | A2 | 0.08 | 8.74 | 42 | 672 | 8.88 | 101 | 97 |
| Example 6 | B | 0.16 | 8.76 | 55 | 671 | 8.90 | 100 | 98 |
| Example 7 | C | 0.16 | 8.81 | 53 | 657 | 8.93 | 101 | 96 |
| Comparative Example 2 | - | 0 | 8.68 | 38 | 689 | 8.96 | 100 | 100 |
| | | | | | | | | |
| Example 8 | A2 | 0.08 | 2.78 | 19 | 1100 | 10.17 | 97 | 94 |
| Comparative Example 3 | - | 0 | 2.84 | 38 | 1084 | 10.23 | 100 | 100 |

[Table 2]

Table 2

| | Anionic polymer | | Polishing composition | | | | Evaluation | |
|---|---|---|---|---|---|---|---|---|
| | Type | Content [g/L] | pH | Absolute value of zeta potential [mV] | ORP [mV] | Electrical conductivity [mS/cm] | Relative polishing removal rate [%] | Relative coefficient of friction [%] |
| Example 9 | A1 | 0.32 | 6.44 | 14 | 871 | 8.76 | 108 | 91 |
| Example 10 | A1 | 0.64 | 6.62 | 14 | 857 | 8.87 | 108 | 88 |
| Example 1 | A2 | 0.08 | 5.88 | 15 | 846 | 8.72 | 104 | 90 |
| Example 11 | A2 | 0.32 | 6.38 | 15 | 867 | 8.71 | 103 | 85 |
| Example 12 | A2 | 0.64 | 6.58 | 15 | 860 | 8.71 | 102 | 86 |
| Example 2 | B | 0.16 | 6.82 | 42 | 802 | 8.92 | 103 | 86 |
| Example 13 | B | 0.32 | 6.55 | 42 | 857 | 9.01 | 104 | 85 |
| Example 3 | C | 0.16 | 4.59 | 27 | 935 | 8.76 | 100 | 81 |
| Example 14 | C | 0.32 | 6.06 | 28 | 889 | 8.93 | 105 | 76 |
| Example 1 5 | C | 0.64 | 6.25 | 28 | 872 | 9.15 | 90 | 77 |

(continued)

| | Anionic polymer | | Polishing composition | | | | Evaluation | |
|---|---|---|---|---|---|---|---|---|
| | Type | Content [g/L] | pH | Absolute value of zeta potential [mV] | ORP [mV] | Electrical conductivity [mS/cm] | Relative polishing removal rate [%] | Relative coefficient of friction [%] |
| Comparative Example 1 | - | 0 | 5.66 | 14 | 859 | 8.85 | 100 | 100 |

was reduced significantly while maintaining the polishing removal rate at the same or higher level, compared to Comparative Example 1, 2 or 3 which did not contain an anionic polymer and showed the pH in the same range as the respective examples.

Further, as illustrated in Table 2, even when the content of the anionic polymer in the polishing composition was increased, it was confirmed that a high friction reduction effect was exhibited while maintaining a favorable polishing removal rate.

<Test Example 2>

<Preparation of polishing composition>

(Example 16)

A silica abrasive, hydrogen peroxide ($H_2O_2$) and sodium metavanadate ($NaVO_3$) as the oxidant, an anionic polymer, and deionized water were mixed to prepare a polishing composition of this example. The content of the silica abrasive was 29%, the content of $H_2O_2$ was 0.405 mol/L, the content of $NaVO_3$ was 0.196 mol/L, and the content of the anionic polymer was 0.32 g/L. The pH of the polishing composition was adjusted to be a value shown in Table 3 by using nitric acid and/or potassium hydroxide (KOH). As the silica abrasive, a colloidal silica having a BET diameter of 72 nm was used. The BET diameter of the abrasive was measured using the surface area measuring device (product name "Flow Sorb II 2300"), manufactured by Micromeritics Instrument Corp. As the anionic polymer, an acrylic acid/2-acrylamido-2-methylpropanesulfonic acid copolymer sodium salt (polymer C) having a Mw of 10000 was used.

(Example 17)

A polishing composition of this example was prepared in the same procedure as in Example 16 except that the content of the anionic polymer was set as shown in Table 3.

(Comparative Example 4)

A polishing composition of this example was prepared in the same procedure as in Example 16 except that no anionic polymer was used.

<Preliminary polishing of object to be polished>

An alumina abrasive (6 % by weight) having a BET diameter of 0.5 $\mu$m and a permanganic acid (0.105 mol/L) as an oxidant were mixed, and a pH adjustment agent was added to the mixture such that a pH of the mixture was 8 or more and 10 or less, thereby preparing a preliminary polishing composition. Then, preliminary polishing was performed on a SiC wafer using the preliminary polishing composition until the following surface qualities were obtained. The conditions for the preliminary polishing were the same as the polishing conditions in the <Polishing of object to be polished> chapter below.

The preliminary polishing was performed such that the surface roughness Ra, measured with an atomic force microscope (model nanoscope V), manufactured by Bruker corporation, was less than or equal to 0.07 nm with regard to the surface quality after the preliminary polishing.

<Polishing of object to be polished>

Polishing was performed on the polished surface of the object to be polished after the preliminary polishing, directly using the polishing compositions of respective examples as the polishing slurry under the following conditions.

[Polishing conditions]

Polishing machine: model "RDP-500" manufactured by Fujikoshi Machinery Corp.
Polishing pad: "SUBA800XY" manufactured by Nitta Haas Incorporated
Polishing pressure: 29.4 kPa
Flow rate of polishing slurry: 20 mL/minute
Platen rotational speed: 100 rpm
Head rotational speed: 100 rpm
Polishing time: 1 hour
Object to be polished: SiC wafer (conductivity type: n-type, crystalline type 4H-SiC, off angle with respect to the C axis of the main surface (0001): 4°), 2 inches, 1 sheet/batch Temperature of polishing slurry: 23°C

<Evaluation of polishing removal rate>

Polishing was performed directly using the polishing compositions of respective examples as the polishing slurry under the above polishing conditions. The polishing rate was calculated according to the calculation formulas (1) and (2) in the same procedure as the above Test Example 1. The resulting values were converted into relative values on the assumption that a corresponding value of the comparative example showing a pH in the same range as the used polishing composition was 100%, and the converted values are shown in the "Relative polishing removal rate" column of Tables 3.

<Evaluation of coefficient of friction>

The coefficient of friction was measured when polishing was performed directly using the polishing composition of each example as the polishing slurry under the above polishing conditions. When measuring the coefficient of friction, the same method as Test Example 1 described above was performed. The resulting value here was converted into a relative value on the assumption that a corresponding value of the comparative example showing a pH in the same range as the used polishing composition was 100%, and the converted values are shown in the "Relative coefficient of friction" columns of Table 3.

[Table 3]

Table 3

|  | Anionic polymer | | Polishing composition | Evaluation | |
|  | Type | Content [g/L] | pH | Relative polishing removal rate [%] | Relative coefficient of friction [%] |
|---|---|---|---|---|---|
| Example 16 | C | 0.32 | 6.35 | 101 | 92 |
| Example 17 | C | 0.64 | 6.28 | 106 | 89 |
| Comparative Example 4 |  | 0 | 6.45 | 100 | 100 |

As illustrated in Table 3, in the polishing compositions of Examples 16 and 17 which contained a silica abrasive, an oxidant, and an anionic polymer, the coefficient of friction was reduced significantly while maintaining the polishing removal rate at the same or higher level, compared to Comparative Example 4 which did not contain an anionic polymer and showed the pH in the same range as the respective examples.

While specific examples of the present invention have been described above in detail, these are only examples, and do not limit the scope of the claims. The techniques recited in the claims include various modifications and alternations of the specific examples exemplified above.

**Claims**

1. A polishing composition comprising:

   water, an abrasive, and a composite metal oxide as an oxidant,
   wherein the polishing composition further contains an anionic polymer.

2. The polishing composition according to claim 1,
   wherein the anionic polymer is a homopolymer or copolymer that contains, in one molecule, at least one of a sulfonic acid-derived structural unit, a (meth)acrylic acid-derived structural unit, or an acrylamide-derived structural unit.

3. The polishing composition according to claim 1 or 2,
   wherein the anionic polymer is a homopolymer or copolymer that contains, in one molecule, at least one structural unit derived from styrenesulfonic acid, isoprene sulfonic acid, vinylsulfonic acid, allylsulfonic acid, isoamylene sulfonic acid, 2-(meth)acrylamido-2-methylpropanesulfonic acid, or methallylsulfonic acid.

4. The polishing composition according to claim 1 or 2,
   wherein the anionic polymer is a homopolymer or copolymer that contains, in one molecule, at least one structural unit derived from acrylic acid or methacrylic acid.

5. The polishing composition according to any one of claims 1 to 4,
   wherein the anionic polymer is a copolymer that contains a sulfonic acid-derived structural unit, a (meth)acrylic acid-derived structural unit, and an acrylamide-derived structural unit.

6. The polishing composition according to any one of claims 1 to 5,
   wherein the composite metal oxide contains a permanganate.

7. The polishing composition according to any one of claims 1 to 6,
   wherein a pH is 2.5 or higher and 9.0 or lower.

8. The polishing composition according to any one of claims 1 to 7,
   wherein the polishing composition is used for polishing a material having a Vickers hardness of 1500 Hv or higher.

9. The polishing composition according to claim 8,
   wherein the material having the Vickers hardness of 1500 Hv or higher is a non-oxide.

10. A method for polishing an object to be polished, comprising the step of polishing the object to be polished using the polishing composition according to any one of claims 1 to 9.

## INTERNATIONAL SEARCH REPORT

| International application No. |
|---|
| PCT/JP2020/023398 |

**A. CLASSIFICATION OF SUBJECT MATTER**
C09K 3/14(2006.01)i; B24B 37/00(2012.01)i; H01L 21/304(2006.01)i
FI: C09K3/14 550Z; C09K3/14 550D; B24B37/00 H; H01L21/304 622D

According to International Patent Classification (IPC) or to both national classification and IPC

**B. FIELDS SEARCHED**

Minimum documentation searched (classification system followed by classification symbols)
C09K3/14; B24B37/00; H01L21/304

Documentation searched other than minimum documentation to the extent that such documents are included in the fields searched
Published examined utility model applications of Japan　　　　1922–1996
Published unexamined utility model applications of Japan　　　1971–2020
Registered utility model specifications of Japan　　　　　　　1996–2020
Published registered utility model applications of Japan　　　1994–2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2016/158328 A1 (MITSUI MINING & SMELTING CO., LTD.) 06.10.2016 (2016-10-06) paragraphs [0007], [0013], [0020], claims 1-13 | 1-2,4,6-10<br>3,5 |
| X<br>Y | WO 2009/031389 A1 (JSR CORPORATION) 12.03.2009 (2009-03-12) claims 1, 3-4, paragraphs [0017], [0043], [0054], [0066], [0072] | 1-4,7,10<br>5-6 |
| X<br>Y | WO 2017/221660 A1 (FUJIFILM CORPORATION) 28.12.2017 (2017-12-28) paragraphs [0009], [0023]-[0024], [0027], [0046], [0053], [0060], claims 1, 3, 6, 10 | 1-2,4,6-10<br>3,5 |
| X<br>Y | WO 2018/128849 A1 (CABOT MICROELECTRONICS CORPORATION) 12.07.2018 (2018-07-12) paragraphs [0004], [0016], [0019], [0024], claims 1, 4-7 | 1-3,7-10<br>4-5 |

☒ Further documents are listed in the continuation of Box C. ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 31 August 2020 (31.08.2020) | 08 September 2020 (08.09.2020) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

| | International application No. |
| --- | --- |
| | PCT/JP2020/023398 |

C (Continuation).  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2009-295747 A (HITACHI CHEMICAL INDUSTRY CO., LTD.) 17.12.2009 (2009-12-17) claims 1, 5-6, paragraphs [0001], [0011], [0016], [0025]-[0026], [0035], [0042], [0049] | 1-4,6-10<br>5 |
| Y | JP 2017-182849 A (FUJIMI INCORPORATED) 05.10.2017 (2017-10-05) claim 1, paragraphs [0014], [0022], [0059]-[0060], [0062], [0065], [0071] | 3-5 |
| Y | JP 2017-183297 A (HITACHI CHEMICAL CO., LTD.) 05.10.2017 (2017-10-05) claims 1, 3-4, paragraphs [0042]-[0043], [0053] | 3-5 |
| Y | WO 2013/035539 A1 (ASAHI GLASS CO., LTD.) 14.03.2013 (2013-03-14) claims, paragraphs [0001], [0020], [0024], [0029], [0032], [0035], [0038]-[0039] | 6 |
| A | JP 2017-182858 A (FUJIMI INCORPORATED) 05.10.2017 (2017-10-05) entire text | 1-10 |
| A | JP 2006-086353 A (FUJI PHOTO FILM CO., LTD.) 30.03.2006 (2006-03-30) entire text | 1-10 |

Form PCT/ISA/210 (continuation of second sheet) (January 2015)

INTERNATIONAL SEARCH REPORT
Information on patent family members

International application No.

PCT/JP2020/023398

| Patent Documents referred in the Report | Publication Date | Patent Family | Publication Date |
|---|---|---|---|
| WO 2016/158328 A1 | 06 Oct. 2016 | (Family: none) | |
| WO 2009/031389 A1 | 12 Mar. 2009 | US 2010/0221918 A1 paragraphs [0017], [0046], [0057], [0071], [0077], claims 1, 3-4 KR 10-2010-0049626 A | |
| WO 2017/221660 A1 | 28 Dec. 2017 | CN 109312211 A KR 10-2019-0007025 A | |
| WO 2018/128849 A1 | 12 Jul. 2018 | JP 2020-505756 A US 2018/0190506 A1 EP 3565862 A1 KR 10-2019-0095499 A CN 110168034 A | |
| JP 2009-295747 A | 17 Dec. 2009 | (Family: none) | |
| JP 2017-182849 A | 05 Oct. 2017 | (Family: none) | |
| JP 2017-183297 A | 05 Oct. 2017 | WO 2016/021708 A1 | |
| WO 2013/035539 A1 | 14 Mar. 2013 | US 2014/0187043 A1 paragraphs [0002], [0020], [0029], [0034], [0037], [0040], [0043]-[0044] CN 103782370 A KR 10-2014-0062107 A | |
| JP 2017-182858 A | 05 Oct. 2017 | (Family: none) | |
| JP 2006-086353 A | 30 Mar. 2006 | (Family: none) | |

**EP 3 985 078 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019112283 A
- JP 2000049124 A
- JP 2012135863 A
- WO 2018116521 A
- WO 2016158328 A